# FASCICULE DE BREVET EUROPEEN

(11) **EP 2 956 967 B1**
(45) Date de publication et mention de la délivrance du brevet: **05.10.2022**
(21) Numéro de dépôt: 14707240.9
(22) Date de dépôt: 11.02.2014
(51) Int. Cl.: H01L 31/0236, H01L 31/042

(54) **STRUCTURE PHOTOVOLTAIQUE POUR CHAUSSÉE**
FOTOVOLTAIKSTRUKTUR FÜR EINE STRASSE
PHOTOVOLTAIC STRUCTURE FOR A ROADWAY

(30) Priorité: 12.02.2013 FR 1351191
(43) Date de publication de la demande: 23.12.2015
(73) Titulaire: Commissariat à l'Énergie Atomique et aux Énergies Alternatives, 75015 Paris (FR); COLAS, 92100 Boulogne-Billancourt (FR)
(72) Inventeur: BARRUEL, Franck, 73370 Le Bourget Du Lac (FR); COQUELLE, Eric, 78000 Versailles (FR); GAUTIER, Jean-Luc, 78280 Guyancourt (FR); PILAT, Eric, 73100 Brison-Saint-Innocent (FR)
(74) Mandataire: Jacobacci Coralis Harle
(86) Numéro de dépôt international: PCT/IB2014/058908
(87) Numéro de publication internationale: WO 2014/125415

(56) Documents cités:
- EP-A1- 1 088 798
- JP-A- H0 918 041
- JP-A- 2002 021 036
- US-A1- 2005 199 282
- US-A1- 2011 302 858
- Gandil P: "Circulaire no 2002-39 du 16 mai 2002 relative à l'adhérence des couches de roulement neuves et au contrôle de la macrotexture", , 16 May 2002 (2002-05-16), pages 1-6, XP055884073, Retrieved from the Internet: URL:https://www.bulletin-officiel.developp ement-durable.gouv.fr/documents/Bulletinof ficiel-0011689/A0100052.pdf;jsessionid=79E 1413C6B82893CA74F07E74099052B [retrieved on 2022-01-26]
- Dupont Pierre: "Mesure de la macrotexture des revêtements de chaussée Normes en cours de validité", , 18 December 2009 (2009-12-18), pages 1-3, XP055884077, Retrieved from the Internet: URL:https://www.idrrim.com/ressources/publ ications/1/395,Note-04.pdf [retrieved on 2022-01-26]

## Description

La présente invention concerne les structures photovoltaïques, destinées en particulier à former une chaussée convenant à la circulation des piétons et des véhicules et présentant notamment une surface extérieure reproduisant la texture d'un enduit superficiel routier et circulable.

### État de la technique

Il existe un besoin pour utiliser les routes comme moyen de production d'énergie pendant la journée, que ce soit pour alimenter des bâtiments situés à proximité (entreprises, éco quartiers, maisons individuelles...) ou pour alimenter le réseau électrique ou des dispositifs d'aide à la circulation.

Du fait de l'importance de la superficie du réseau routier, cela pourrait permettre d'éviter les champs de modules solaires qui utilisent des terres arables pour la production d'énergie ou de démultiplier les surfaces actuellement utilisables telles que des toitures.

US 2005/0199282 A1 divulgue une chaussée incorporant une structure photovoltaïque, comportant des cellules solaires recouvertes par un revêtement non opaque devant supporter le poids des véhicules et procurer un coefficient de friction suffisant pour permettre à ceux-ci de circuler sans déraper.

A titre d'exemples de revêtements, sont cités des matériaux tels que des matières plastiques transparentes revêtues en surface d'une couche résistant à l'abrasion, le verre trempé ou recuit, un complexe formé de billes de verre de 5 mm liées par une résine époxy sur du verre recuit, avec une préférence pour un complexe formé d'acrylique doublé de polycarbonate.

La structure peut présenter en surface des éléments de friction destinés à accroître le coefficient de friction. Ces éléments de friction peuvent être disposés selon des motifs tels que des lignes courbes ou droites, courtes ou longues, des cercles ou autres figures géométriques.

Les éléments de friction peuvent être formés par des barres ou pics ou par des rainures découpées à la surface du revêtement. Les éléments de friction, lorsque rapportés, peuvent être en acier inoxydable ou en polycarbonate.

Il existe un besoin pour perfectionner encore les structures photovoltaïques destinées à la circulation des piétons ou véhicules.

### Résumé

L'invention a pour objet, selon un premier de ses aspects, une structure (encore appelée complexe) photovoltaïque conforme à la revendication 1.

On entend par « irrégulièrement », le fait que les reliefs donnant la macrotexture et la microtexture n'ont pas tous la même forme, ni la même taille. Ces reliefs peuvent être obtenus à partir d'éléments texturants n'ayant pas la même forme ni la même taille, étant non calibrés. La nature, la taille moyenne, le rapport d'aspect moyen et la densité en surface moyenne des éléments texturants sont spécifiquement choisis de manière à obtenir les valeurs de PMT et de PSV souhaitées.

A la différence de la structure de texture régulière présentée dans la demande de brevet US2005/0199282, une structure selon la présente invention présente en surface une dispersion irrégulière, de préférence aléatoire, d'éléments de relief non-opaques de forme elle-même irrégulière et de préférence aléatoire, qui se rapproche de l'aspect de surface d'un enduit superficiel bien connu de l'industrie routière. Elle dispose de plus à la fois de topographies à l'échelle macroscopique (macrotexture) et microscopique (microtexture) propices à l'adhérence. De ce fait, les caractéristiques de surface particulières de la présente invention sont choisies pour présenter des niveaux propices de macrotexture et de microtexture répondant à des spécifications en termes de PMT et de PSV rendant le revêtement apte à la circulation.

D'autre part, la présente invention est de préférence réalisée à l'aide d'éléments texturants tels que des grains de verre qui 1) répliquent la texture d'une route et fournissent des propriétés d'adhérence mesurées conformes aux spécifications (BO 2002-10 : circulaire 2002-39 du 16 mai 2002 relative à l'adhérence des couches de roulement neuves et au contrôle de la macrotexture) et 2) sont applicables si cela est souhaité sur chantier en utilisant les engins et techniques des Travaux Publics.

Dans une de ses réalisations, la structure selon la présente invention se présente comme une unité photovoltaïque encapsulée circulable.

Le revêtement d'une structure selon l'invention permet, grâce à la texture de sa surface extérieure, de présenter l'adhérence convenant à la circulation des véhicules ou piétons, tout en protégeant efficacement les cellules photovoltaïques disposées sous celui-ci.

L'invention permet de ne pas remplacer les chaussées existantes ; la structure selon l'invention peut s'adapter à la plupart de celles-ci sans nécessiter de décaissements ou la pose de blocs photovoltaïques épais et rigides.

De plus, l'invention permet d'utiliser le savoir-faire et les équipements habituels servant à la fabrication et à l'entretien des revêtements des routes (finisseurs, épandage de liant et de gravier,...)

Ainsi, l'invention permet une implantation aisée de la structure photovoltaïque et, d'un point de vue économique, de réduire significativement les coûts de pose et d'intégration.

Les caractéristiques d'adhérence du revêtement selon l'invention sont de préférence proches de celles des revêtements routiers bitumineux traditionnels et les caractéristiques optiques sont compatibles avec l'obtention d'un rendement de conversion satisfaisant de l'énergie solaire en énergie électrique.

La structure photovoltaïque selon l'invention peut être réalisée selon deux modalités d'exécution notamment.

Selon une première modalité d'exécution, les cellules photovoltaïques sont présentes au sein d'un ou plusieurs modules recouverts par le revêtement non opaque et texturé, le ou les modules s'interposant entre ce revêtement et la route sous-jacente. En particulier, le revêtement peut selon cette première modalité d'exécution aussi s'étendre à la partie de la route supportant les modules photovoltaïques mais non recouverte par ceux-ci, ou bien se limiter à la seule surface des modules. Ces derniers peuvent être fixés à la chaussée par une couche d'accroche.

Selon une deuxième modalité d'exécution, les cellules photovoltaïques sont encapsulées dans le revêtement non opaque et texturé, le revêtement s'étendant alors de préférence à la fois au-dessus et en dessous des cellules photovoltaïques. Le revêtement peut s'étendre au contact d'une couche d'accroche déposée sur la route ou directement au contact de celle-ci. Notamment, selon cette deuxième modalité d'exécution, le revêtement peut être pré-assemblé avec un ou plusieurs modules photovoltaïques, contenant les cellules photovoltaïques, de préférence en utilisant un moule.

L'invention a encore pour objet, selon un autre de ses aspects, indépendamment ou en combinaison avec ce qui précède, une structure photovoltaïque convenant à la circulation des piétons et des véhicules, comportant au moins une cellule photovoltaïque encapsulée dans un revêtement non opaque, présentant une surface extérieure texturée, irrégulière, et convenant à la circulation des véhicules et des piétons.

L'invention a encore pour objet, selon un autre de ses aspects, indépendamment ou en combinaison avec ce qui précède, une structure photovoltaïque convenant à la circulation des piétons et des véhicules, comportant au moins une cellule photovoltaïque recouverte par un revêtement présentant une surface extérieure texturée avec un relief irrégulier, défini par des granulats de forme irrégulière.

L'invention a encore pour objet, selon un autre de ses aspects, indépendamment ou en combinaison avec ce qui précède, une structure photovoltaïque convenant à la circulation des piétons et des véhicules, comportant un revêtement recouvrant au moins une cellule photovoltaïque, ce revêtement comportant un liant bitumineux, un liant routier clair de synthèse ou d'origine végétale, des résines, colles ou polymères, comme de l'époxy ou du polyuréthane, et éventuellement des éléments texturants tels que des granulats ou grains en verre, assurant une texturation en surface.

L'invention a encore pour objet, selon un autre de ses aspects, indépendamment ou en combinaison avec ce qui précède, une structure photovoltaïque permettant de réaliser une chaussée, sous forme de nappe flexible enroulée, à dérouler pour former la surface de roulement, comportant des cellules photovoltaïques et un revêtement les recouvrant, ce revêtement ayant une surface extérieure texturée.

Selon tous ces objets de l'invention, le revêtement peut être tel que défini par la suite, de même que les éléments texturants utilisés.

L'invention a encore pour objet un procédé de fabrication d'une structure photovoltaïque, notamment selon le premier aspect tel que défini ci-dessus, comportant les étapes consistant à :
- disposer des éléments texturants, de préférence des granulats de forme irrégulière, notamment aléatoire, dans le fond d'un moule, les éléments texturants étant de préférence disposés selon une monocouche
- disposer une ou plusieurs cellules photovoltaïques dans le moule,
- injecter ou couler dans le moule un matériau non opaque à l'état fluide pour enrober la ou les cellules photovoltaïques et retenir les éléments texturants. De préférence, les éléments texturants sont disposés avec une densité de surface donnée.

L'invention a encore pour objet un procédé de fabrication d'une structure photovoltaïque, notamment selon le premier aspect tel que défini ci-dessus, comportant les étapes consistant à :
- disposer une ou plusieurs cellules photovoltaïques dans un moule,
- injecter ou couler dans le moule un matériau non opaque à l'état fluide,
- avant durcissement dudit matériau, incruster à sa surface des éléments texturants, de préférence des granulats de forme irrégulière, notamment aléatoire, les éléments texturants étant de préférence disposés selon une monocouche.

L'invention a encore pour objet un procédé de fabrication d'une structure photovoltaïque, notamment selon le premier aspect tel que défini ci-dessus, comportant les étapes consistant à :
- disposer une ou plusieurs cellules photovoltaïques dans un moule,
- déposer sur la ou les cellules photovoltaïques un film en polymère transparent, d'épaisseur donnée,
- déposer à sa surface des éléments texturants, de préférence des granulats de forme irrégulière, notamment aléatoire, les éléments texturants étant de préférence disposés selon une monocouche,
- soumettre l'ensemble à un laminateur à chaud et sous pression, la chaleur assurant le ramollissement du film et permettant aux granulats de s'y incruster. De préférence, les éléments texturants sont disposés avec une densité de surface donnée.

Dans tous les procédés faisant intervenir des éléments texturants, ces derniers sont de préférence emprisonnés entre un quart et trois quarts de leur hauteur, de préférence à mi-hauteur environ. La réalisation d'une monocouche est préférable pour des questions de performances photovoltaïques.

Ainsi, dans un premier mode de réalisation, des éléments texturants tels que des granulats transparents sont répandus à refus, et idéalement en monocouche, sur le fond d'un moule. Une fois que le matériau transparent qui y aura été injecté ou moulé aura atteint ses propriétés mécaniques finales, les granulats seront enchâssés dans le matériau et assureront une texturation en surface.

Dans un second mode de réalisation, des granulats transparents sont insérés en surface du complexe photovoltaïque moulé, et idéalement avant que le matériau transparent injecté ou moulé n'ait totalement durci.

### Revêtement

Le revêtement selon l'invention est avantageusement réalisé de manière à présenter des caractéristiques techniques convenant à la fois à la circulation des piétons et des véhicules mais permettant aussi son utilisation dans le domaine photovoltaïque. En particulier, ces caractéristiques concernent la transparence et la texturation de surface dudit revêtement.

### Transparence

Afin de garantir les performances photovoltaïques recherchées, le revêtement est non opaque. Il présente avantageusement un taux de transparence entre 50 et 95%.

Pour caractériser le taux de transparence, un spectrophotomètre équipé d'une sphère dite intégrante est utilisé. Cet appareil permet de quantifier la lumière qui traverse directement l'échantillon et celle qui est diffusée par l'échantillon, pour une plage de valeurs de longueurs d'onde, par pas de 5 nm par exemple, cette plage étant de préférence située autour du pic d'efficacité des cellules photovoltaïques, plus ou moins 100 nm.

Le taux de transparence est mesuré pour l'épaisseur de revêtement traversée par la lumière incidente sur la face de roulement, avant d'atteindre les cellules photovoltaïques.

Le revêtement à caractériser est mis en œuvre sur une plaque de verre. Cette plaque est au préalable caractérisée en transparence en utilisant le même spectrophotomètre. On effectue la mesure conformément au protocole décrit ci-dessus et on soustrait les valeurs de transparence obtenues de celles de la plaque de verre.

Pour avoir une caractérisation de l'efficacité optique de la structure selon l'invention, on pondère les valeurs de transmission par la réponse spectrale (sensibilité suivant les longueurs d'onde) des cellules photovoltaïques, dont les sensibilités dans le bleu (450-520 nm) et dans le violet (380-450) peuvent être différentes selon le type de technologie employé. L'efficacité maximale des technologies actuelles étant dans le vert autour de 600 nm, le revêtement est de préférence réalisé de telle sorte que dans la plage 500 à 700 nm, son taux de transparence soit supérieur à 50%.

### Texturation de surface:

Afin de garantir les performances d'adhérence recherchées, le revêtement selon l'invention est avantageusement réalisé de manière à présenter une surface extérieure, qui soit à la fois macrotexturée et microtexturée.

### Macrotexture

La macrotexture du revêtement caractérise les irrégularités de surface dans la gamme 0,5 à 50 mm horizontalement (selon la norme NF EN ISO 13473-1) ; la macrotexture facilite l'évacuation de l'eau en surface de la structure selon l'invention et permet d'éviter des pertes d'adhérence pneu/chaussée par temps de pluie.

Une macrotexture présente une longueur d'onde de texture allant de 50 mm à 0,5 mm et une microtexture une longueur d'onde de texture inférieure à 0,5 mm.

La macrotexture présente de préférence un relief irrégulier, qui est avantageusement obtenu grâce à un choix bien défini d'éléments texturants, avec une taille et une densité en surface spécifiquement choisis, de forme irrégulière, notamment aléatoire, tels que des granulats.

Par ailleurs, la surface extérieure du revêtement présente une profondeur de macrotexture de préférence telle que la profondeur moyenne de texture PMT mesurée selon la norme NF EN 13036-1 est au moins de 0,20 mm, et préférentiellement 0,30 mm, et idéalement 0,60 mm ou plus, étant de préférence comprise entre 0,2 mm et 3 mm.

### Microtexture

La surface du revêtement présente aussi une microtexture, afin d'assurer la bonne adhérence des pneumatiques.

La microtexture caractérise les irrégularités de surface dont la dimension horizontale caractéristique est inférieure à 0,5 mm, selon la norme NF EN ISO 13473-1.

L'adhérence du revêtement de l'invention vis-à-vis de la circulation, traduisant la qualité de la microtexture, doit persister après un polissage, et peut être exprimée :
- en termes de coefficient de frottement µ_{WS}, mesuré avec une machine Wehner und Schulze. Une telle machine procède tout d'abord jusqu'à 180 000 cycles de polissage de la surface à mesurer (disque de diamètre 225 mm), obtenus par trois cônes sous un mélange d'eau et de silice. Dans un second temps le dispositif accélère une tête supportant trois patins à base caoutchoutique d'une taille 30 mm x 14,5 mm chacun jusqu'à 3000 tours par minute, ce qui correspond à une vitesse tangentielle de 100 km/h. De l'eau à 10 °C est pulvérisée sur la surface à caractériser jusqu'à ce qu'un film d'eau d'épaisseur théorique 0,5 mm soit formé. A ce moment, les patins sont appliqués sur la surface à mesurer avec une pression de 0,2 N.mm⁻², équivalent à une pression de pneumatique de 2 bars. Le coefficient de frottement µ_{WS} est calculé à la vitesse de 60 km/h, et peut être ramené en termes de polished stone value PSV ;
- en termes de Polished Stone Value (PSV), en utilisant un patin de frottement tel que décrit dans la norme NF EN 1097-8. Le revêtement selon l'invention présente avantageusement une valeur de PSV selon la norme NF EN 13043 d'au moins PSV₄₄, préférentiellement PSV₅₀, et idéalement PSV₅₃.

### Caractère irrégulier de la texture

Le revêtement selon l'invention présente une surface extérieure macrotexturée irrégulièrement et également microtexturée irrégulièrement.

Il faut comprendre que le relief de la macrotexture ou de la microtexture ne se reproduit pas à l'identique, en raison de l'emploi d'éléments texturants n'ayant pas la même forme ni la même taille, n'étant pas calibrés. Le relief peut présenter un caractère aléatoire, aussi bien au niveau de sa macrotexture que de sa microtexture. Les éléments texturants sont par exemple des éclats ou grains de verre, comme précisé plus loin.

### Description détaillée

L'invention pourra être mieux comprise à la lecture de la description qui va suivre, d'exemples de mise en œuvre non limitatifs celle-ci, et à l'examen du dessin annexé, sur lequel :
- la figure 1 représente de façon schématique, en coupe prise dans l'épaisseur, un exemple de chaussée équipée d'une structure photovoltaïque selon l'invention,
- la figure 2 est une vue analogue à la figure 1, d'une variante de réalisation de la structure photovoltaïque,
- les figures 3A à 3E illustrent la réalisation d'une structure et son utilisation selon un exemple de mise en œuvre de l'invention, et
- les figures 4A à 4E sont des vues analogues aux figures 3A à 3E, de variantes de mise en œuvre de l'invention.

Sur le dessin, les proportions relatives des différents éléments constitutifs n'ont pas toujours été respectées, dans un souci de clarté. De même, les éléments texturants ont été représentés très schématiquement, en nombre réduit, pour simplifier le dessin. Les éléments de connexion électrique, conventionnels, n'ont pas été représentés.

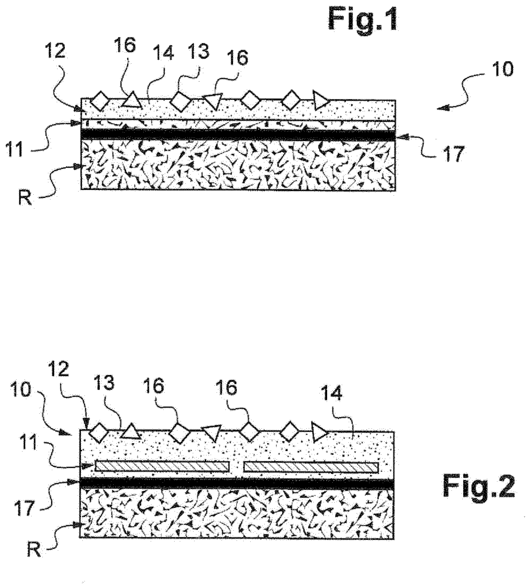

Un premier exemple de structure photovoltaïque 10 selon l'invention est représenté à la figure 1. La structure 10 comporte un ou plusieurs modules 11 à cellules photovoltaïques et un revêtement transparent 12 recouvrant ce ou ces modules 11.

Le revêtement 12 protège mécaniquement les cellules photovoltaïques tout en permettant la circulation des piétons et véhicules et sa transparence permet une production d'énergie électrique par les modules 11.

La structure 10 présente une surface extérieure 13 granuleuse, irrégulière, présentant de préférence un relief aléatoire.

Le revêtement 12 est par exemple formé, comme illustré, d'un liant 14, encore appelé matrice, dans lequel sont incrustés des éléments texturants 16 transparents, tels que des granulats formés d'éclats de verre ou de grains de verre, donnant son aspect granuleux à la surface extérieure 13. La texture du revêtement peut également être réalisée par structuration de la surface, sans inclusion de granulats dans le liant.

Les termes « transparent », « translucide » et «non opaque» sont considérés comme synonymes dans le cadre de la présente invention.

La texture du revêtement 12 garantit une tenue de route similaire aux routes « classiques », avec de préférence des valeurs de PMT et PSV telles que définies plus haut.

Les modules photovoltaïques 11 peuvent être flexibles ou semi-rigides, voire rigides.

Une couche d'accroche 17 peut assurer la fixation du ou des modules 11 sur la route R, qui peut être neuve ou existante.

L'exemple de la figure 1 correspond à la première modalité d'exécution de l'invention, définie plus haut, selon laquelle le revêtement 12 s'étend au-dessus du ou des modules photovoltaïques 11 et ne s'interpose pas entre ces derniers et la route sous-jacente. D'autres variantes seront décrites plus loin.

Quelles que soient les réalisations, le liant utilisé présente de préférence un taux de transparence allant de 80 à 100%.

De préférence, on choisit le matériau du revêtement de telle sorte que celui-ci reste transparent dans le temps, ce dont on peut s'assurer *via* des tests de vieillissement en enceinte climatique, en suivant par exemple la norme NFT 30-049. Le revêtement ne perdra pas plus de 20% après 5 jours de vieillissement au WOM (« weather o meter ») selon la norme NFT 30-049 et de préférence pas plus de 10% de sa transparence initiale.

La structure illustrée à la figure 1 peut être réalisée en répandant le liant à l'état fluide sur la surface des modules photovoltaïques 11, et avant que le liant ne durcisse, les éléments texturants 16 (de préférence sous forme de granulats transparents de forme irrégulière) peuvent être répandus à refus sur la surface.

Le dosage en liant peut être réalisé selon le savoir-faire routier traditionnel afin d'emprisonner les inclusions formées par les éléments texturants, de préférence à mi-hauteur environ.

### Exemples de réalisation du revêtement

Selon un premier exemple de réalisation du revêtement, le liant est de type bitumineux tel que défini dans la norme NF EN 12591, clair c'est-à-dire dépigmenté, dont les classes de pénétrabilité déterminées selon la méthode EN 1426 peuvent être, sans limitation, 160/220, 100/150, 70/100, 50/70, 40/60, 35/50, 30/45 ou 20/30 (en dixième de millimètre). On citera par exemple le liant Bituclair commercialisé par la société Colas.

Selon un second exemple de réalisation du revêtement, le liant est un liant routier clair de synthèse ou d'origine végétale dont les classes de pénétrabilité déterminées selon la méthode EN 1426 peuvent être, sans limitation, 160/220, 100/150, 70/100, 50/70, 40/60, 35/50, 30/45 ou 20/30 (en dixième de millimètre). On citera par exemple les liants Végécol ou Végéclair commercialisés par la société Colas.

Selon un troisième exemple de réalisation du revêtement, le liant est de nature purement synthétique ou d'origine végétale, le liant étant de préférence de nature organique, préférentiellement de nature polymérique. On citera à titre d'exemple et sans limitation une résine acrylique, époxy ou polyuréthane, comme les vernis époxydiques dits Vernis D commercialisés par la société Résipoly, ou encore un polyuréthane Sovermol commercialisé par la société BASF.

Les liants utilisés dans l'invention peuvent comprendre des initiateurs ou des catalyseurs, notamment pour accélérer le durcissement. Ils peuvent aussi comprendre des additifs, épaississants, fluxants ou autres pour faciliter l'épandage et l'obtention d'une surface filmogène d'épaisseur contrôlée.

Les liants utilisés présentent une bonne tenue aux UV (tant en termes de transparence que de propriétés mécaniques), à l'eau, à la chaleur, au froid et au gel, ce que l'on peut vérifier en enceinte climatique en suivant par exemple la norme NFT 30-049, ainsi qu'une bonne adhérence aux éléments texturants 16 et à la surface des modules photovoltaïques 11. De plus, ces liants possèdent avantageusement une flexibilité proche du complexe composé par la surface de roulement de la route existante et des modules photovoltaïques, à savoir idéalement un module élastique compris entre 0,1 et 10 GPa.

Les exemples de revêtements donnés ci-dessus valent pour toutes structures selon l'invention.

### Exemples d'éléments texturants

La réalisation d'une monocouche d'éléments texturants 16 est préférable pour des questions de performances photovoltaïques, car la transmission optique chute avec l'épaisseur de matériau.

Le choix de la nature, de la granulométrie, du facteur de forme et de la densité en surface des éléments texturants vise à obtenir :
- une bonne angularité, autorisant une bonne adhérence entre les pneumatiques et la chaussée, dans des conditions sèches ou humides : la macrotexture ainsi obtenue permet l'évacuation de l'eau sous le pneumatique, tandis que la microtexture contribue à l'adhérence ; une texture aléatoire définie par des éléments texturants de forme aléatoire ou reproduisant le relief d'éléments texturants de forme aléatoire est de ce point de vue avantageuse ;
- une résistance à l'abrasion pour conserver au fil du temps la qualité de la tenue de route recherchée ; l'utilisation en tant qu'éléments texturants de matériaux minéraux, de grande dureté, est avantageuse de ce point de vue ;
- un bon état de surface pour assurer une adhésion au liant correcte ; l'utilisation de granulats de forme irrégulière, notamment aléatoire peut contribuer au bon accrochage de ceux-ci à la matrice ;
- une bonne transparence, pour conserver les performances photovoltaïques.

Les éléments texturants sont avantageusement des matériaux transparents (verre, polycarbonate...), préférentiellement en verre, éclats ou grains, préférablement des grains de verre (verre neuf ou recyclé concassé).

La taille de ces éléments, discriminée au tamis, peut être mono ou poly disperse, et aller de 0,1 à 10 mm, mieux de à 0,4 à 4 mm, et préférablement encore d'une taille allant de 0,9 à 1,4 mm.

Afin d'obtenir le niveau en macrotexture souhaité, la densité en surface de ces éléments texturants en surface du revêtement est comprise de préférence entre 0,1 et 5kg/m², et avantageusement entre 0,7 et 1,5kg/m².

Le facteur de forme de ces éléments structurants, c'est-à-dire le rapport pour un élément entre sa plus grande longueur et sa plus petite largeur, est de préférence inférieur ou égal à 8 et de préférence compris entre 1 et 3.

La profondeur moyenne de texture PMT de tels éléments avoisine de préférence 0,8 mm et répond au seuil idéal de 0,6 mm, tandis qu'en termes d'adhérence et de résistance au polissage, après 180 000 cycles de polissage à la machine Wehner und Schultze, les éléments texturants présentent de préférence un coefficient de frottement µ_{WS} de 0,4, dépassant le seuil µ_{WS}=0,30 d'une Polished Stone Value 50.

Les exemples d'éléments texturants ci-dessus valent pour toutes les réalisations.

Les modules photovoltaïques 11 peuvent être minces, flexibles ou semi-rigides (par exemple des modules photovoltaïques de marque Unisolar) et être collés à même la surface d'une route réalisée en enrobés ou en béton de ciment. La face arrière des modules 11 est de préférence suffisamment rigide et solide pour protéger les cellules photovoltaïques contre tout poinçonnement par les aspérités de surface de la route existante (par exemple par les têtes de granulats), tout en épousant l'évolution de la topographie de surface des routes (par exemple suite à la formation d'ornières ou une fissuration). Par exemple, la face arrière des modules 11 est définie par une résine fluorée telle que de l'éthylène-tétrafluoroéthylène, par exemple celle commercialisée sous la dénomination Tefzel par la société DuPont, de préférence d'épaisseur 0,2 à 5 mm.

La chaussée peut être neuve ou existante, étant de préférence réalisée à partir de formules d'enrobés peu orniérantes, de sorte que la topographie de la surface de la route n'évolue que faiblement au fur et à mesure du passage des véhicules.

Le collage des modules 11 à la surface de la route R est réalisé avec la couche d'accroche 17, laquelle peut être formée de colles industrielles spéciales, ou encore d'un liant bitumineux, éventuellement renforcé par un ajout d'un polymère tel que du SBS, à chaud ou en émulsion.

Dans une première réalisation, la colle ou le liant bitumeux formant la couche d'accroche 17 est directement répandu sur la surface de la route R, étalé en couche mince, puis les modules photovoltaïques 11 y sont déposés alors que la colle n'a pas durcie ou que le liant bitumineux est encore visqueux et collant.

Dans une seconde réalisation, le liant destiné à former la couche d'accroche 17 est déposé en usine sur la face inférieure des modules photovoltaïques 11, face qui peut être brute ou avoir subi un traitement plasma ou corona pour promouvoir une meilleure adhésion au liant ; le complexe ainsi obtenu est alors collé sur la route R par un réchauffage léger du liant au dos des modules 11. Le complexe correspondant à cette deuxième réalisation peut être posé sur une route neuve ou existante.

On va maintenant décrire, en se référant à la figure 2, une structure photovoltaïque 10 selon la seconde modalité d'exécution de l'invention définie plus haut, dans laquelle la ou les cellules photovoltaïques 11 sont encapsulées dans le revêtement 12. Ce dernier peut également être fixé sur la route R par une couche d'accroche 17, à l'instar de l'exemple précédemment décrit en référence à la figure 1.

L'encapsulation assure la protection (mécanique, hygrométrique, étanchéité...) des cellules photovoltaïques.

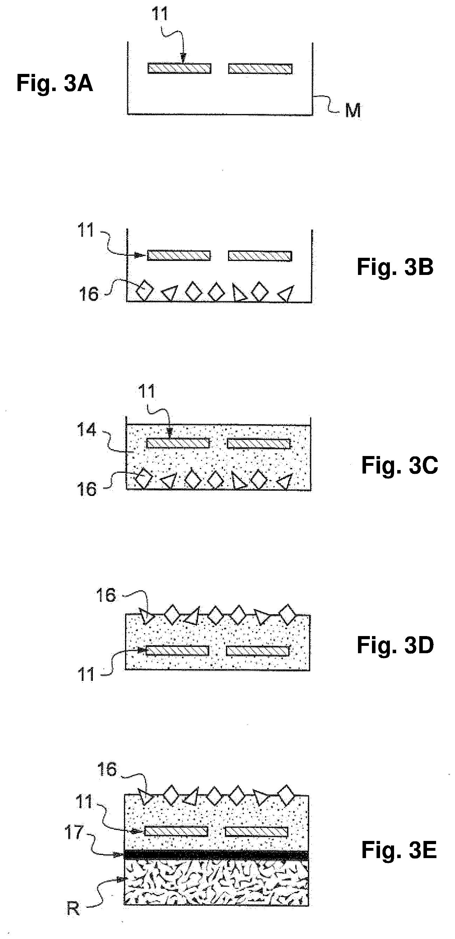

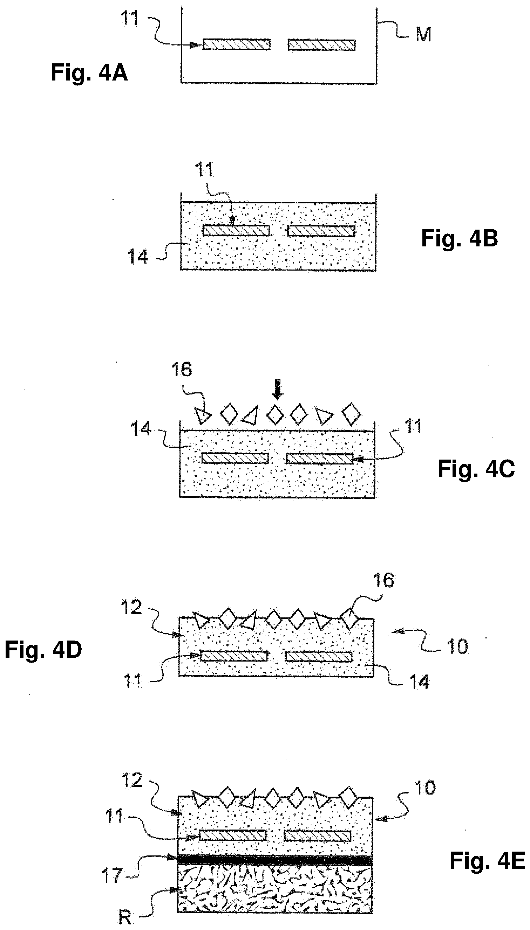

L'encapsulation est de préférence réalisée en prépositionnant la ou les cellules photovoltaïques 11 au sein d'un moule comme illustré aux figures 3A ou 4A, et détaillé ci-après. Ensuite, la structure 10 est démoulée et peut être fixée sur la route existante R grâce à la couche d'accroche 17.

Pour réaliser la texture de surface du revêtement, dans un premier mode de réalisation, illustré sur les figures 3A à 3E, des éléments texturants 16 tels que des granulats transparents sont répandus à refus sur le fond d'un moule, de préférence sous le forme d'une monocouche, dans ce qui sera ensuite la face de roulement de la structure. Un liant transparent 14 est ensuite injecté ou versé dans le moule. Une fois que ce matériau a atteint sa dureté et ses propriétés mécaniques finales, les granulats sont solidarisés au contenu du moule et assurent la texturation de surface recherchée.

Dans un second mode de réalisation, illustré sur les figures 4A à 4E, le liant transparent 14 est d'abord injecté ou versé dans le moule (figure 4B), puis les éléments texturants tels que des granulats transparents sont répandus sur la surface libre du moule (figure 4C), alors que le matériau injecté ou coulé n'a pas atteint ses propriétés finales et se présente encore comme un fluide visqueux. Les éléments texturants peuvent être enfoncés dans le liant *via* une contrainte mécanique ou s'enfoncer par le biais de leur propre poids ; il est encore possible de chauffer les éléments texturants pour faire fondre le liant en leur voisinage immédiat. Une fois que le liant 14 a atteint sa dureté et ses propriétés mécaniques finales, les granulats sont solidarisés au contenu du moule et assurent la texturation de surface recherchée (figure 4D).

Ces deux premiers modes de réalisation utilisent des éléments texturants 16 ajoutés au liant 14 pour donner au revêtement 12 la texture recherchée, de préférence sous la forme d'une monocouche.

Dans une troisième réalisation, on :
- dépose un film en polymère transparent, d'épaisseur donnée, sur la ou les cellules photovoltaïques,
- dépose à sa surface des éléments texturants, notamment des granulats de forme irrégulière, mieux aléatoire, les éléments texturants étant de préférence disposés selon une monocouche, et l'on soumet ces éléments à un laminateur à chaud et sous pression. La chaleur assure le ramollissement du film et permet aux granulats de s'y incruster.

Comme encapsulant utilisable pour réaliser l'invention selon la deuxième modalité d'exécution, on peut utiliser tout matériau transparent (taux de transparence entre 80 et 100%) capable d'être versé ou injecté dans un moule, au sein duquel ont été prépositionnées des cellules photovoltaïques.

Le rôle du liant est de protéger mécaniquement les cellules photovoltaïques, de permettre le maintien des éléments texturants éventuels qui vont donner à la surface sa texture, et donc permettre la tenue de route recherchée, tout en étant et en restant transparents dans le temps (en répondant au test de vieillissement en enceinte climatique selon la norme NFT 30-049 par exemple).

Le liant peut être le même que selon la première modalité de mise en œuvre de l'invention (voir le chapitre « Exemples de réalisation du revêtement » plus haut) et présenter les mêmes caractéristiques.

Ainsi, selon un premier exemple, le liant est de type bitumineux tel que défini dans la norme NF EN 12591, clair (dépigmenté), dont les classes de pénétrabilité déterminées selon la méthode EN 1426 peuvent être, sans limitation, 160/220, 100/150, 70/100, 50/70, 40/60, 35/50, 30/45 ou 20/30 (en dixième de millimètre). On citera par exemple le liant Bituclair commercialisé par la société Colas.

Selon un second exemple, le liant est un liant routier clair de synthèse ou d'origine végétale dont les classes de pénétrabilité déterminées selon la méthode EN 1426 peuvent être, sans limitation, 160/220, 100/150, 70/100, 50/70, 40/60, 35/50, 30/45 ou 20/30 (en dixième de millimètre). On peut utiliser les liants Végécol ou Végéclair commercialisés par la société Colas.

Selon un troisième exemple, le liant est de nature purement synthétique ou d'origine végétale, de préférence de nature organique, préférentiellement de nature polymérique. On citera à titre d'exemple et sans limitation une résine acrylique, époxy ou polyuréthane, comme les vernis époxydiques dit Vernis D commercialisés par la société Résipoly, ou encore un polyuréthane Sovermol commercialisé par la société BASF.

Les éléments texturants peuvent être les mêmes que ceux listés au chapitre «Exemples d'éléments texturants ». Le choix de la nature et de la granulométrie de ces inclusions répond aux mêmes critères que ceux définis plus haut. A titre d'exemple, des granulats en verre, d'une taille comprise entre 0.9 et 1.4mm, peuvent être utilisés comme éléments texturants en combinaison avec du polyuréthane de type Sovermol comme liant. Le taux de transparence d'un tel revêtement est compris entre 60 et 95% à 600nm et idéalement à 95%. Les valeurs de PSV sont de préférence d'au moins PSV₄₄, mieux PSV₅₀, encore mieux PSV₅₃, et la profondeur moyenne de texture PMT est de préférence comprise entre 0,2 et 3 mm.

En fonction des objectifs de transparence et de protection mécanique, l'épaisseur de la structure photovoltaïque 10 selon l'invention va par exemple de 0,5 à 30 mm, idéalement de 0,6 à 12 mm. Il n'est pas nécessaire que les épaisseurs de liant au-dessus et en dessous des modules ou des cellules photovoltaïques 11 soient identiques.

Le collage de la structure photovoltaïque selon cette deuxième modalité d'exécution de l'invention à la surface de la route peut être réalisé avec des colles industrielles spéciales, ou encore avec un liant bitumineux, éventuellement renforcé par un ajout d'un polymère tel que du SBS, à chaud ou en émulsion.

Dans une première réalisation, le liant est directement répandu sur la surface de la route, étalé en couche mince, puis la structure photovoltaïque préfabriquée y est déposée alors que la colle n'a pas durcie ou que le liant bitumineux est encore visqueux et collant.

Dans une seconde réalisation, le liant est déposé en usine sur la face inférieure de la structure photovoltaïque préfabriquée, face qui peut être brute ou avoir été traitée par plasma ou effet corona pour promouvoir une meilleure adhésion du liant ; la structure photovoltaïque est alors collée sur la route par un réchauffage léger du liant présent au dos de celle-ci.

La face avant peut être réalisée lors de la fabrication de la structure photovoltaïque en usine.

La face de roulement peut aussi être réalisée sur le chantier routier, après avoir étalé les modules ou les cellules photovoltaïques sur les premières couches bitumineuses.

Une structure photovoltaïque selon l'invention peut encore être proposée sous la forme d'un complexe déroulable à grand rayon de courbure, texturé, que la face supérieure (après déroulement) soit déjà prétexturée ou que l'on y adjoigne une couche à base de liant transparent portant des éléments texturants tels que des granulats transparents. Le complexe peut inclure des pistes et des connectiques électriques souples. Un engin de chantier peut être utilisé pour dérouler le complexe sur une route existante.

Dans une troisième réalisation, le revêtement est avantageusement réalisé par imprégnation à l'aide d'un rouleau. La structure photovoltaïque est disposée sur la route à recouvrir, et un rouleau préalablement imprégné de liant, notamment de résine, est passé sur la structure à la façon d'une application de peinture.

### Chaussée

De façon générale, la chaussée peut être neuve ou existante, mais de préférence réalisée à partir de formules d'enrobés peu orniérantes, de sorte que la topographie de la surface de la route n'évolue que faiblement au fur et à mesure du passage des véhicules. La chaussée peut être une route, une autoroute, un trottoir.

### Utilisation de l'énergie électrique produite

L'énergie électrique produite par une structure photovoltaïque selon l'invention peut être utilisée de diverses manières, par exemple dans des écoquartiers, fermes solaires, alimenter de l'éclairage public, la signalisation routière ou la recharge des voitures électriques, cette liste n'étant pas limitative.

L'invention peut également être utilisée pour tous types d'applications où la notion d'adhérence est importante ou pour des motivations esthétiques.

L'expression « comportant un » doit être comprise comme étant synonyme de « comportant au moins un ».

## Revendications

1. Structure photovoltaïque (10), pour chaussée convenant à la circulation des piétons et des véhicules, comportant :
- au moins une cellule photovoltaïque,
- un revêtement non opaque (12), recouvrant au moins la face avant de ladite cellule photovoltaïque et présentant une surface extérieure (13) qui est, à la fois, macrotexturée irrégulièrement et microtexturée irrégulièrement, la macrotexture présentant des irrégularités de surface dans la gamme 0,5 à 50 mm horizontalement, la microtexture présentant des irrégularités de surface dont la dimension horizontale caractéristique est inférieure à 0,5 mm, ladite surface extérieure (13) permettant la circulation des piétons et des véhicules, une profondeur de macrotexture présentant une profondeur moyenne de texture PMT mesurée selon la norme NF EN 13036-1 comprise entre 0,2 mm et 3 mm, ledit revêtement non opaque (12) présentant une valeur de résistance au polissage PSV selon la norme NF EN 13043 d'au moins PSV₄₄, mieux PSV₅₀, encore mieux PSV₅₃, la profondeur moyenne de texture PMT étant de préférence d'au moins 0,30 mm, mieux d'au moins 0,6 mm,
ledit revêtement non opaque (12) étant formé d'un liant (14) et d'éléments texturants non opaques (16) ayant une taille allant de 0,4 à 4mm, lesdits éléments texturants formant des reliefs de différentes formes et différentes tailles de manière à obtenir la macrotexture et la microtexture.

2. Structure selon la revendication précédente, le revêtement (12) ayant un taux de transparence supérieur à 50 % dans une plage de 100 nm autour du pic d'efficacité des cellules photovoltaïques, notamment dans la plage 500-700 nm.

3. Structure selon l'une des revendications précédentes, ledit liant (14) est de préférence de module élastique compris entre 0,1 et 10 GPa, la cellule photovoltaïque étant de préférence enrobée par le liant (14), la texture de la surface extérieure (13) étant de préférence définie au moins partiellement par ledit liant (14).

4. Structure selon la revendication 3, le liant (14) étant choisi parmi les matériaux d'origine synthétique ou végétale, les liants bitumineux, de préférence de classe de pénétrabilité selon la norme EN 1426 160/220,100/150,70/100,50/70,40/60,35/50,30/45 ou 20/30 (en dixième de mm), les liants routiers clairs de synthèse ou d'origine végétale, de préférence de classe de pénétrabilité selon la norme EN 1426 160/220,100/150,70/100,50/70,40/60,35/50,30/45 ou 20/30 (en dixième de mm) et les liants polymériques.

5. Structure selon l'une quelconque des revendications précédentes, la densité en éléments texturants en surface du revêtement est de préférence comprise entre 0,1 et 5kg/m², mieux entre 0,7 et 1,5 kg/m2, les éléments texturants ayant de préférence un facteur de forme inférieur à 8, mieux compris entre 1 et 3.

6. Structure selon la revendication 5, les éléments texturants (16) étant disposés selon une monocouche, de préférence enfoncés à mi-épaisseur environ dans le liant (14) du revêtement.

7. Structure selon l'une des revendications 5 et 6, les éléments texturants (16) étant choisis parmi les granulats de matériaux transparents ou translucides, organiques ou minéraux, notamment de polycarbonate ou de verre.

8. Structure selon l'une quelconque des revendications 5 à 7, les éléments texturants ayant une taille allant de 0,9 à 1,4 mm.

9. Structure selon l'une quelconque des revendications précédentes comportant une couche d'un polymère, éventuellement fluoré, sous la cellule photovoltaïque, de préférence d'une épaisseur allant de 0,2 à 5 mm.

10. Chaussée équipée d'une structure photovoltaïque (10) telle que définie dans l'une quelconque des revendications précédentes.

11. Procédé de fabrication d'une structure photovoltaïque telle que définie dans l'une quelconque des revendications 1 à 9, comportant les étapes consistant à:
- disposer des éléments texturants dans le fond d'un moule (M), notamment des granulats de forme irrégulière, de préférence aléatoire, les éléments texturants étant de préférence disposés selon une monocouche,
- disposer une ou plusieurs cellules photovoltaïques dans le moule,
- injecter ou couler dans le moule un matériau non opaque à l'état fluide pour enrober les cellules photovoltaïques, et retenir les éléments texturants.

12. Procédé de fabrication d'une structure photovoltaïque telle que définie dans l'une quelconque des revendications 1 à 9, comportant les étapes consistant à :
- disposer une ou plusieurs cellules photovoltaïques dans un moule,
- injecter ou couler dans le moule un matériau non opaque à l'état fluide,
- avant durcissement dudit matériau, incruster à sa surface des éléments texturants, notamment des granulats de forme irrégulière, de préférence aléatoire, les éléments texturants étant de préférence disposés selon une monocouche.

13. Procédé de fabrication d'une structure photovoltaïque telle que définie dans l'une quelconque des revendications 1 à 9, comportant les étapes suivantes :
- déposer un film en polymère transparent sur une ou plusieurs cellules photovoltaïques,
- déposer à sa surface des éléments texturants, de préférence de forme irrégulière, mieux aléatoire,
- soumettre l'ensemble à un laminateur à chaud et sous pression, la chaleur assurant le ramollissement du film et permettant aux éléments texturants de s'y incruster.

## Patentansprüche

1. Fotovoltaikstruktur (10) für eine für den Verkehr von Fußgängern und Fahrzeugen geeignete Straße mit
- mindestens einer Fotozelle,
- einer nicht undurchsichtigen Beschichtung (12), die mindestens die Vorderseite der Fotozelle bedeckt und eine äußere Oberfläche (13) aufweist, die gleichermaßen unregelmäßig makrostrukturiert und unregelmäßig mikrostrukturiert ist, wobei die Makrostruktur Oberflächenunregelmäßigkeiten im Bereich von horizontal 0,5 bis 50 mm aufweist, wobei die Mikrostruktur Oberflächenunregelmäßigkeiten aufweist, deren charakteristische horizontale Abmessung kleiner als 0,5 mm beträgt, wobei die äußere Oberfläche (13) den Verkehr von Fußgängern und Fahrzeugen ermöglicht, wobei eine Tiefe der Makrostruktur eine nach der Norm NF EN 16043 gemessene mittlere Strukturtiefe PMT zwischen 0,2 und 3 mm aufweist, wobei die nicht undurchsichtige Beschichtung (12) einen Abriebfestigkeitswert PSV gemäß der Norm NF EN 13043 von mindestens PSV₄₄, besser PSV₅₀, noch besser PSV₅₃ aufweist, wobei die mittlere Strukturtiefe PMT vorzugsweise mindestens 0,30 mm, besser mindestens 0,6 mm, beträgt,
wobei die nicht undurchsichtige Beschichtung (12) aus einem Bindemittel (14) und nicht undurchsichtigen Strukturelementen (16) mit einer Größe von 0,4 bis 4 mm gebildet ist, wobei die Strukturelemente Reliefs verschiedener Formen und verschiedener Größen bilden, um die Makrostruktur und die Mikrostruktur zu erhalten.

2. Struktur gemäß dem vorangehenden Anspruch, wobei die Beschichtung (12) einen Durchsichtigkeitsgrad von mehr als 50 % in einem Bereich von 100 nm um den Spitzenwert der Wirksamkeit der Fotozellen herum, insbesondere im Bereich 500 - 700 nm, aufweist.

3. Struktur gemäß einem der vorangehenden Ansprüche, wobei das Bindemittel (14) vorzugsweise ein Elastizitätsmodul zwischen 0,1 und 10 GPa aufweist, wobei die Fotozelle vorzugsweise vom Bindemittel umgeben ist, wobei die Struktur der äußeren Oberfläche (13) vorzugsweise mindestens teilweise durch das Bindemittel (14) definiert ist.

4. Struktur gemäß Anspruch 3, wobei das Bindemittel (14) unter den Materialien synthetischen oder pflanzlichen Ursprungs, den bituminösen Bindemitteln, vorzugsweise der Durchlässigkeitsklassen 160/220, 100/150, 70/100, 50/70, 40/60, 35/50, 30/45 oder 20/30 (in Zehntelmillimetern) nach der Norm EN 1426, den hellen Bindemitteln für Verkehrswege synthetischen oder pflanzlichen Ursprungs, vorzugsweise der Durchlässigkeitsklassen 160/220, 100/150, 70/100, 50/70, 40/60, 35/50, 30/45 oder 20/30 (in Zehntelmillimetern) nach der Norm EN 1426, und den polymeren Bindemitteln ausgewählt ist.

5. Struktur gemäß einem der vorangehenden Ansprüche, wobei die Dichte an Strukturelementen an der Oberfläche der Beschichtung vorzugsweise zwischen 0,1 und 5 kg/m², besser zwischen 0,7 und 1,5 kg/m², beträgt, wobei die Strukturelemente vorzugsweise einen Formfaktor von weniger als 8, besser zwischen 1 und 3, aufweisen.

6. Struktur gemäß Anspruch 5, wobei die Strukturelemente (16) einschichtig angeordnet sind, vorzugsweise ungefähr bis in die Mitte der Dicke des Bindemittels (14) der Beschichtung eingedrückt sind.

7. Struktur gemäß einem der Ansprüche 5 und 6, wobei die Strukturelemente (16) unter den Granulaten aus durchsichtigen oder durchscheinenden, organischen oder anorganischen Materialien, insbesondere aus Polykarbonat oder Glas, ausgewählt sind.

8. Struktur gemäß einem der Ansprüche 5 bis 7, wobei die Strukturelemente eine Größe von 0,9 bis 1,4 mm aufweisen.

9. Struktur gemäß einem der vorangehenden Ansprüche mit einer Schicht aus einem Polymer, gegebenenfalls fluoriert, unter der Fotozelle, vorzugsweise mit einer Dicke von 0,2 bis 5 mm.

10. Fahrbahn mit einer wie in einem der vorangehenden Ansprüche definierten Fotozellenstruktur (10).

11. Verfahren zum Herstellen einer wie in einem der Ansprüche 1 bis 9 definierten Fotozellenstruktur, das die folgenden Schritte aufweist:
- Ablegen von Strukturelementen, insbesondere von Granulaten unregelmäßiger, vorzugsweise zufälliger Form auf dem Boden einer Form (M), wobei die Strukturelemente vorzugsweise einschichtig abgelegt werden,
- Ablegen einer oder mehrerer Fotozellen in der Form,
- Einspritzen und Gießen eines nicht undurchsichtigen Materials im flüssigen Zustand in die Form, um die Fotozellen zu beschichten und die Strukturelemente festzuhalten.

12. Verfahren zum Herstellen einer wie in einem der Ansprüche 1 bis 9 definierten Fotozellenstruktur, das die folgenden Schritte aufweist:
- Ablegen einer oder mehrerer Fotozellen in einer Form,
- Einspritzen und Gießen eines nicht undurchsichtigen Materials im flüssigen Zustand in die Form,
- Einbringen von Strukturelementen, insbesondere von Granulaten unregelmäßiger, vorzugsweise zufälliger Form vor dem Erhärten des Materials in dessen Oberfläche, wobei die Strukturelemente vorzugsweise einschichtig eingebracht werden.

13. Verfahren zum Herstellen einer wie in einem der Ansprüche 1 bis 9 definierten Fotozellenstruktur, das die folgenden Schritte aufweist:
- Aufbringen eines durchsichtigen Polymerfilms auf eine oder mehrere Fotozellen,
- Aufbringen von Strukturelementen unregelmäßiger, vorzugsweise zufälliger Form auf dessen Oberfläche,
- die Gesamtheit heiß und unter Druck einer Walze aussetzen, wobei die Hitze das Erweichen des Films sicherstellt und ermöglicht, daß die Strukturelemente in diesen eindringen.

## Claims

1. A photovoltaic structure (10) for a roadway suitable for pedestrian and vehicular traffic, comprising:
- at least one photovoltaic cell,
- a non-opaque surfacing (12), covering at least the front face of said photovoltaic cell and having an outer surface (13) which is both irregularly macrotextured and irregularly microtextured, the macrotexture comprising surface irregularities in the range 0.5 to 50 mm horizontally, the microtexture comprising surface irregularities which characteristic horizontal size of which is less than 0.5 mm, said outer surface (13) allowing pedestrian and vehicular traffic, a macrotexture depth having a mean texture depth MTD measured according to the NF EN 13036-1 standard comprised between 0.2 mm and 3 mm, the non-opaque surfacing (12) having a PSV value of resistance to polishing according to the NF EN 13043 standard of at least PSV₄₄, better still PSV₅₀, even better still PSV₅₃, the mean texture depth MTD being at least 0.30 mm, better still at least 0.6 mm,
said non-opaque surfacing (12) being formed from a binder (14) and non-opaque texturing elements (16) having a size ranging from 0.4 to 4 mm, said texturing elements forming reliefs with different shapes and different sizes in order to obtain the macrotexture and the microtexture.

2. The structure according to the preceding claim, the surfacing (12) having a degree of transparency of greater than 50% in a range of 100 nm around the peak of efficiency of the photovoltaic cells, in particular in the range 500-700 nm.

3. The structure according to any one of the preceding claims, said binder (14) preferably has an elastic modulus of between 0.1 and 10 GPa, the photovoltaic cell being preferably embedded by the binder (14), the texture of the outer surface (13) being preferably defined at least partially by said binder (14).

4. The structure according to claim 3, the binder (14) being selected from materials of synthetic or plant origin, bituminous binders, preferably having a penetration class according to the EN 1426 standard of 160/220, 100/150, 70/100, 50/70, 40/60, 35/50, 30/45 or 20/30 (in tenths of mm), and clear road binders of synthetic or plant origin, preferably having a penetration class according to the EN 1426 standard of 160/220, 100/150, 70/100, 50/70, 40/60, 35/50, 30/45 or 20/30 (in tenths of mm) and polymeric binders.

5. The structure according to any one of the preceding claims, the density of texturing elements at the surface of the surfacing being between 0.1 and 5 kg/m², better still between 0.7 and 1.5 kg/m², the texturing elements having preferably a shape factor of less than 8, better still of between 1 and 3.

6. The structure according to claim 5, the texturing elements (16) being arranged in a single layer, preferably sunk to mid-thickness approximately in the binder (14) of the surfacing.

7. The structure according to any one of claims 5 and 6, the texturing elements (16) being selected from aggregates of organic or mineral, transparent or translucent materials in particular of polycarbonate or of glass.

8. The structure according to any one of claims 5 to 7, the texturing elements having a size ranging from 0.9 mm to 1.4 mm.

9. The structure according to any one of the preceding claims, comprising a layer of a polymer, which is optionally fluorinated, beneath the photovoltaic cell, preferably having a thickness ranging from 0.2 to 5 mm.

10. A roadway equipped with a photovoltaic structure (10) as defined in any one of the preceding claims.

11. A process for manufacturing a photovoltaic structure as defined in any one of claims 1 to 9, comprising the steps consisting in:
- positioning texturing elements in the bottom of a mold (M), in particular aggregates of irregular, preferably random, shape, the texturing elements preferably being arranged in a single layer,
- positioning one or more photovoltaic cells in the mold,
- injecting or casting a non-opaque material in the fluid state into or in the mold in order to cover the photovoltaic cells, and retain the texturing elements.

12. A process for manufacturing a photovoltaic structure as defined in any one of claims 1 to 9, comprising the steps consisting in:
- positioning one or more photovoltaic cells in a mold,
- injecting or casting a non-opaque material in the fluid state into or in the mold,
- before curing said material, embedding texturing elements, in particular aggregates of irregular, preferably random, shape, in its surface, the texturing elements preferably being arranged in a single layer.

13. A process for manufacturing a photovoltaic structure as defined in any one of claims 1 to 9, comprising the following steps:
- depositing a transparent polymer film on one or more photovoltaic cells,
- depositing texturing elements, preferably of irregular, preferably random, shape, on its surface,
- subjecting the assembly to a hot pressurized laminator, the heat ensuring the softening of the film and enabling the aggregates to be embedded therein.
